Europäisches Patentamt

European Patent Office

Office européen des brevets

(19)

(11) Publication number: 0 315 002
A2

## (12) EUROPEAN PATENT APPLICATION

(21) Application number: 88117647.3

(22) Date of filing: 23.10.88

(51) Int. Cl.4: G06F 15/60

(30) Priority: 02.11.87 US 115473

(43) Date of publication of application:
10.05.89 Bulletin 89/19

(84) Designated Contracting States:
CH DE FR GB IT LI SE

(71) Applicant: SAVOIR
3102 Diablo Avenue
Hayward California 94545(US)

(72) Inventor: Lipkis, Thomas A.
19331 Valley View Drive
Topanga California 90290(US)
Inventor: Mark, William S.
11 Trillium Lane
San Carlos California 94070(US)
Inventor: Pirtle Melvin W.
2219 Main Street
Santa Monica California 90405(US)

(74) Representative: Görtz, Dr. Fuchs, Dr.
Luderschmidt Patentanwälte
Sonnenberger Strasse 100 Postfach 26 26
D-6200 Wiesbaden(DE)

(54) Design system using visual language.

(57) The invention is a computer-based tool, in the form of a computer system and method, for designing, constructing and interacting with any system containing or comprising concurrent asynchronous processes, such as a factory operation. In the system according to the invention a variety of development and execution tools are supported. The invention features a highly visual user presentation of a control system, including structure, specification, and operation, offering a user an interactive capability for rapid design, modification, and exploration of the operating characteristics of a control system comprising asynchronous processes. The invention captures a representation of the system (RS) that is equivalent to the actual system (AS) - rather than a simulation of the actual system. This allows the invention to perform tests and modification on RS instead of AS, yet get accurate results. RS and AS are equivalent because AS is generated directly from RS by an automated process. Effectively, pressing a button in the RS environment can "create" the AS version or any selected portion of it, by "downloading" a translation of the RS version that can be executed by a programmable processor in the AS environment. Information can flow both ways between AS and RS. That AS and RS can interact is important. This allows RS to "take on" the "state" of AS whenever desired, through an "uploading" procedure, thereby reflecting accurately the condition of AS at a specific point in time.

## DESIGN SYSTEM USING VISUAL LANGUAGE

### BACKGROUND OF THE INVENTION

#### Field of the Invention

The present invention relates to computer programs and more particularly to a computer program for designing, constructing and supporting systems of concurrent asynchronous processes.

#### Background and Prior Art

An automated factory is an example of a large complex interactive system. The design of such large complex systems is a significant technological challenge. There is much literature on the subject and there are various computer programs that can assist an engineer in the process of designing an automated system. The existing design aids have a variety of shortcomings and none of them address the entire problem.

For example in the factory environment, there are many automated devices available such as robots, artificial vision systems, and the like. There are also known design aids for automating a single device such as a robot. However, to achieve the next level of automation, a multitude of devices must be coordinated as a composite unit: the factory cell.

In a factory cell, devices operate asynchronously and concurrently. The detailed actions of each device are managed by individual device controllers. The cell control logic must coordinate these device controllers usually by communicating with them over a network or direct link. Optimally, this cell logic must also provide the interface for operators and maintenance personnel. In addition, many applications require the cell to collect data about device performance and part quality. Communication with other parts of the factory may also be a requirement.

A cell system, in broad terms, consists of interacting asynchronous concurrent processes. The fundamental problem of cell control is creating logic for processes that operate and communicate in parallel.

One of the stumbling blocks to complete factory automation is the inability to efficiently configure individual factory processes into productive, cooperative systems. One of the major problems to a coordinated factory automation program is that all processes do not move at the same pace or begin and end in the same field of time as other processes.

Present systems do not include an integrated approach where control programs can be sent to cell controllers for execution on a local controller in an interactive environment. Stated differently, present systems do not provide an completely integrated and interactive specification, design, and operating environment.

#### Objects of the Invention

An object of the present invention is to provide an improved technique for designing complex systems.

Another object is to be able to communicate the behavior and structure of a complex system.

Another object is reduce the time required to design a completely functional system.

Still another object is to provide a means to rapidly prototype a number of different approaches without spending time at the detail level.

Yet another object is to provide diagnostic tools to enable one to discover quickly why an operational system is not behaving as desired.

Another object is to speed up the integration process in a situation where one is trying to verify that each functional element relates accurately to the entire system.

Still another object is to allow a user to deal with the creation and verification process in an integrated manner.

### SUMMARY OF THE INVENTION

The invention is a computer-based tool, in the form of a computer system and method, for designing, constructing and interacting with any system containing or comprising concurrent asynchronous processes, such as a factory operation. In the system according to the invention a variety of development and execution tools are supported. The invention features a highly visual user presentation of the structure, specification, and operation of a control system. The invention offers a user an interactive capability for rapid design, modification, and exploration of the operating characteristics of the system. The invention provides a set of integrated and interactive functional capabilities that help the user produce a complete detailed specification, offering rapid prototyping, comprehensive documentation, system emulation, functional animation, and system analysis capabilities. Specifically, the invention provides an environment supporting the combination of:

a) A high-level, graphic, control-flow language, specifically the international standard Grafcet, for pictorially specifying the structure and detailed interaction of a system of concurrent processes.

b) A low-level logic specification language for setting and testing state variables, transferring information between control processes, collecting data, and other fundamental activities. Specific examples are C and LISP applied as logic specific languages.

c) An emulation capability that "executes" the control specification, visually highlighting the active steps on displayed Grafcet charts, showing the value changes of displayed variables, and displaying the inter-process message traffic of selected processes.

d) An animation capability that helps the user develop a depiction of the controlled devices and manipulate the images as the system is emulated; adding an extra dimension to the graphic display of a functioning control specification.

e) A messaging capability which provides templates for message development, message tracing, message sending and receiving, and which automatically facilitates information transfer in formats which are compatible with standard network protocols, such as the Manufacturing Application Protocol (MAP).

f) Structural depictions that will draw the hierarchical relationship among sub-elements of a process, and also draw the communication interconnection among processes, offering a highly visual operational representation of the entire control structure.

g) Built-in analysis tools which enable the user to locate and examine specific aspects and interactions of a design, to trace emulated operational characteristics, and to time the activities of emulated devices and processes.

h) Documentation facilities which automatically format the process documentation for printing and provide hierarchical diagrams, Grafcet charts, logic program listings, indexing, and a table of contents.

i) A capability to interface with a network, such as a MAP (Manufacturing Automation PRotocol) factory network interface, in a manner to allow the user to substitute selected actual devices for emulated devices and to send message traffic across the network as well as to the on-screen emulation.

j) A direct MAP control capability which allows the user to control a remote device directly by sending messages directly to the device and asking for return status information.

k) An MMI (man machine interface) development capability for assisting the user develop MMI screens for use on the shop floor computer.

l) A download capability for compiling the designer specification and for sending it across the factory network to a run time module in a shop floor computer or device (a cell) for on-floor execution.

m) A monitoring capability which can remotely interact with a downloaded module.

The invention provides a mechanism for capturing a representation of the system (RS) that is equivalent to an actual system (AS) - rather than a simulation of the actual system. This allows the tools according to the invention to perform tests and modifications on the RS instead of the AS, yet get accurate results.

RS and AS are equivalent because AS is generated directly from RS by an automated process. Pressing a button for example in the RS environment can "create" the AS version or any selected portion of it, by "downloading" a translation of the RS version that can be executed by a programmable processor in the AS environment.

Information can flow both ways between AS and RS. That AS and RS can interact is important. This allows RS to "take on" the "state" of AS whenever desired, through an "uploading" procedure, thereby reflecting accurately the condition of AS at a specific point in time. This permits an engineer to explore and dissect, so to speak, the RS version of the system without effecting the AS version that may still be in active operation. This is important for systems that cannot be easily taken out of service for diagnosis or maintenance.

The foregoing and other objects, features and advantages of the invention will be apparent from the following more particular description of preferred embodiments of the invention, as illustrated in the accompanying drawings.

BRIEF DESCRIPTION OF THE DRAWINGS

Figure 1 shows a computer work station used to implement the present invention.

Figure 2 is a functional block diagram of the computer system shown in Figure 1.

Figure 3 is a diagram of an overall automated factory.

Figure 4 is a block diagram showing how an individual cell may be operated and tested.

Figure 5 shows a representative image on the display.

Figure 6 is a hierarchical diagram of a representative group of the programming objects used to implement the system.

## DESCRIPTION OF A SPECIFIC EMBODIMENTS

A specific embodiment of the invention disclosed herein is represented as it might be implemented using a Xerox 1185/86 Artificial Intelligent Work Station. The Xerox 1185/86 Work Station is a computer which provides an object-oriented applications platform and interconnections with other equipment as hereinafter explained. The present invention takes advantage of the speed offered by this work station's micro-coded object-oriented environment, coupling high performance without compromising the object-oriented benefits.

As will be explained later, the computer work station can be coupled to the factory floor through a factory network. Once a design is fully developed and checked-out, the system control can be downloaded to an industrial computer. For later maintenance activity when a powerful diagnostic tool is needed, a reconnection over the network can upload the system's state.

The 1185/86 computer is commercially available from Xerox Corporation, and it is described among other places in the manual published by Xerox entitled "1186 User's Guide" (Manual 3101678, May 1986). This computer utilizes an object oriented programming language which is described in a manual published by Xerox entitled "Interlisp-D Reference Manual Volume 1: Language" (Publication 3101272 October 1985). The above-referenced manuals are hereby incorporated herein by reference.

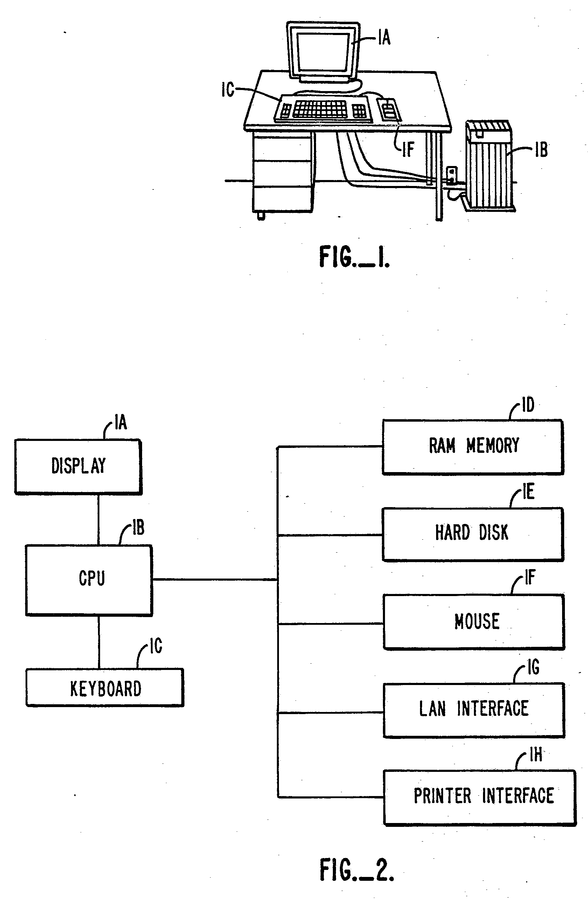

The computer system shown to implement the specific embodiment of the invention is shown in Figure 1. The major components of the system are shown diagrammatically in Figure 2. They include a display 1A, a central processing unit 1B, a keyboard 1C and a mouse 1F. As shown in Figure 2, the system preferably includes 3.7 megabytes of RAM memory 1D and 80 megabytes of Hard Disk storage IE. The display is for example a monochrome 1152 x 861 pixel display. The system may include an Ethernet LAN interface 1G and Laser Printer interface 1H.

In the following discussion, certain commonly used abbreviations will be used. The meaning of these abbreviations are: Flexible Assembly Systems (FAS), Computer Integrated Manufacturing (CIM), Artificial Intelligence (AI); Local Area Network (LAN) and Manufacturing Application Protocol (MAP). The system also uses the Grafcet visual presentation language, which is a well-known manner of presenting and describing information, and the "C" programming language which is a well-known programming language. Since the above are well-documented in the literature, they will not be explained herein.

The present invention provides a tool to support hierarchical top-down design and system implementation. It provides system operational analysis through Grafcet charts, it provides logic state level control through C language functions, and it provides complete system documentation with cross-references, table of contents and indexing.

The environment according to the invention is useful at many levels. On the front-end, while initiating a proposal, the present invention offers rapid prototyping and creation of system proposals and specifications. It can eliminate costly misunderstandings between vendor and user.

At system design, the present invention provides the tools necessary to quickly structure, develop and analyze various approaches. Its speed encourages the exploration of several approaches to find the optimum strategy before implementation begins.

During implementation, the present invention provides a comprehensive set of integration and check-out tools that permit safe and rapid integration. The present invention also aids in the acceptance and test and vendor supplied subsystems.

Once a system is operational, the present invention provides powerful diagnostic capabilities that can analyze the uploaded state of an operational or malfunctioning system.

Finally, the present invention makes the subsequent modification or reconfiguration of even a complex system a straightforward and relatively easy task.

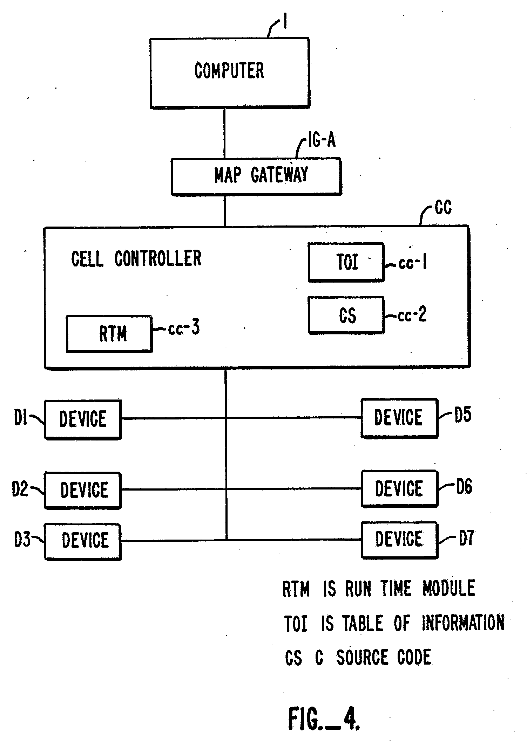

Figure 4 shows how the system interrelates to the various cells in a factory. Cells are the basic units of autonomous operation in a factory. In the embodiment shown, each of the cells 2A to 2J in the factory interrelate through a network using a MAP protocol. The cells 2A to 2J could each be robots or they could be other types of automated equipment. The nature of each of the cells is not important to an understanding of the invention, and they will not be described further.

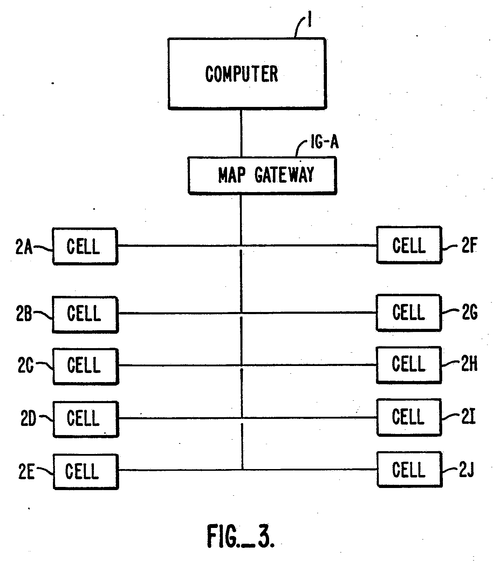

The computer 1 can be connected to the various cells through a LAN interface 1G and a MAP Gateway 1G-A. Thus, the computer 1 can communicate with each of the cells using the MAP protocol. As shown in Figure 3, the computer 1 interrelates with the cells 2A to 2J in an operational environment, and the invention can be used in its monitoring capacity.

Alternatively, the computer 1 can be connected to a single cell as shown in Figure 4. In this case the invention can simulate the rest of the factory, and it can exercise the cell 2A as if the cell 2A were connected to the other machines in the network. With the present invention the same tool used to design the system is thus used to test the individual components of the system and to monitor the system when it is finally operational.

The engineering cycle of the system begins with initial concept, moves through the development and construction phases, becomes a diagnostic and maintenance activity when the system is finally operational, and eventually re-cycles when modification and upgrades are required. The cycle can be described as follows:

1) Specification (developing the requirements and documentation);

2) Design (developing the approach and its documentation);

3) Development (implementing the design and generating its documentation);

4) Simulation and/or Emulation (activating the design implementation in an artificial environment in such a way as to demonstrate the dynamics of the system);

5) Debug (isolate and correct the cause of undesired behavior within a functional element before it is put into service, sometimes using simulation techniques to anticipate its eventual behavior);

6) Translate and transfer the developed system into its operational embodiment;

7) System integration and check-out (the process that verifies that each functional system element will interact and cooperate properly with the other functional elements in the system, usually involves recycling through the debug phase);

8) Monitor and interact with (modify) the operational system;

9) Diagnose malfunctions or unexplained behavior in the operational system; and

10) Modify the system to the extent that the cycle begins again at phase 1 for some portion of the system.

Normally this cycle is a sequential process, with early stages being completed before later stages are possible. Key to the invention is the ability to move freely through this cycle at will, maximizing the utilization of the engineer's creative insight.

One aspect of the invention is the use of a captured representation of the system (RS) that is equivalent to the actual system (AS) - rather than a simulation of the actual system. This allows tests and modification on RS instead of AS, yet get accurate results.

RS is the representation of the system, that is, the design specification of a system expressed in a form suitable for visual presentation on a work station terminal display. AS is the equivalent automatically rewritten in source code at the work station, which can be compiled or interpreted for direct use by the autonomous remote cells with a runtime module. In a specific embodiment, AS is executable code and associated tables of values which can operate with a generic runtime module.

It is a consequence of the invention that AS and RS are equivalent, because AS is generated directly from RS by an automated process. Effectively, pressing a button in the RS environment can "create" the AS version or any selected portion of it, by "downloading" a translation of the RS version that can be executed by a programmable processor in the AS environment.

Information can flow both ways from RS to AS and from AS to RS. That AS and RS can interact is important. This allows RS to "take on" the "state" of AS whenever desired, through an "uploading" procedure, thereby reflecting accurately the condition of AS at a specific point in time. This permits an engineer to explore and dissect, so to speak, the RS version of the system without affecting the AS version that may still be in active operation. This is important for systems that cannot be easily taken out of service for diagnosis or maintenance.

Figure 4 shows how a representative cell is organized. The cell includes a cell controller CC and a number of devices D1 to D7 which are controlled by the cell controller. The cell controller includes a Run Time Module (RTM) cc-3. This RTM manages the execution of the system description that can be sent to it, and it interprets the Grafcet structural information in order to control the sequencing of the programs that actually send commands to the devices D1 to D7. The RTM also acts as the interface with computer 1 to upload a state of the controller and the devices. The computer 1 sends controller CC a Table of Information (TOI) cc-1 that represents the Grafcet structural information and other information such as breakpoint information and variable values. The computer 1 also sends cell controller CC programming source code cc-2. This code is compiled under control of the Run Time Module cc-3 to generate the control programs for the devices D1 to D7.

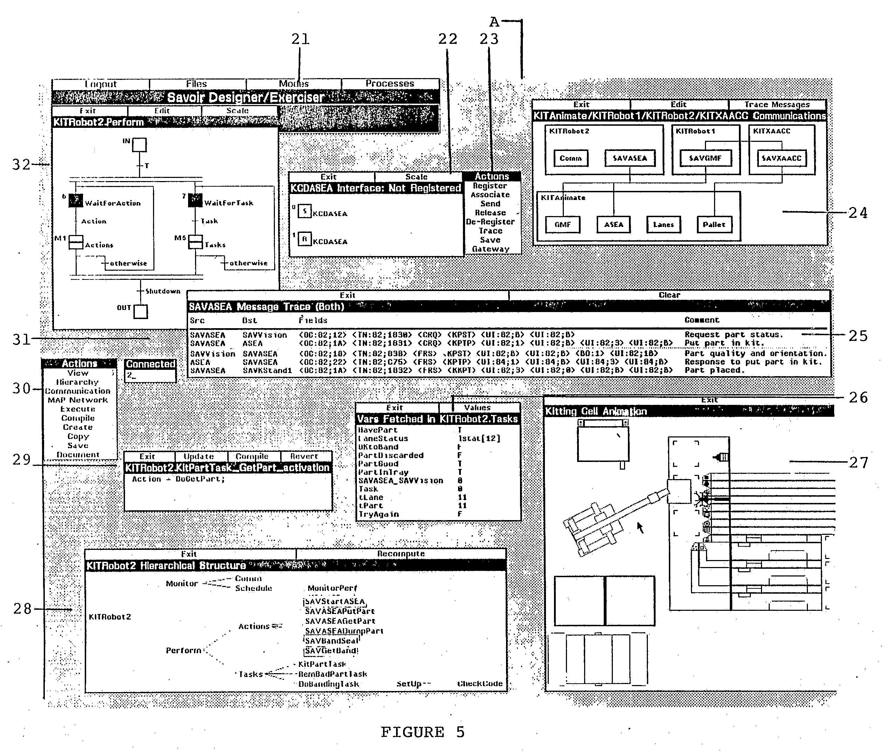

Figure 5 shows a representative screen which appears on display 1A. The screen has the following areas which facilitate communication with the operator. Area 21 is a basic system interface for accessing computer files and processes. Area 22 is the interface to the MAP network. Area 23 is a the menu of items for interacting with the map network. Area 24 is a communication diagram drawn by the system to show how individual functional elements relate to each other. Area 25 is a trace window that displays message traffic between functional elements during operation or simulation. Area 26 is a window that displays the values of selected variables in simulated or operational mode. Area 27 is an animated depiction of the system's functional characteristics. Area 28 is a hierarchical diagram of a selected functional element. Area 29 is a window that displays a C language function within a functional element. Area 30 is the menu of high level activities that the user may select. Area 31 is a user interface to the underlying operating system that runs on the work station. Area 32 is a Grafcet program representing one of the elements in the hierarchical diagram.

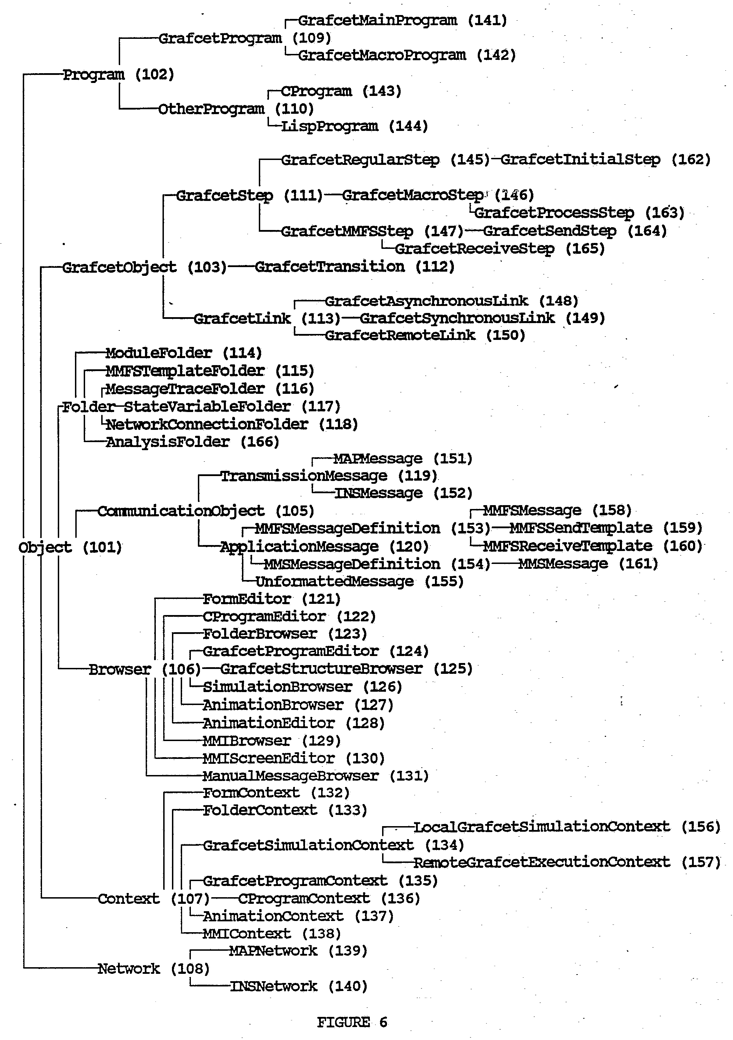

These windows are all created using the facility of the basic underlying operating system which is described in the previously-referenced manuals. The contents of the windows are provided by the programming objects shown in Figure 6.

The programming in computer 1 is an object-type of programming. Such programming, while different from conventional programming, is well known and is described in various textbooks. Object-oriented programming is not described by usual flow diagrams. Rather, it is described by diagrams such as Figure 6. The objects and their interrelationship are shown in Figure 6. The following is a description of the principal objects that comprise the embodiment of the invention shown herein. Item names are the objects found on the hierarchical diagram.

Program 102: A program for executable specification of a program. Programs may be written by the user. Certain programs are provided in libraries as part of the system. Programs may contain other programs as subparts.

Grafcetprogram 109: A specification of control flow written in the Grafcet language. It is made up of GrafcetObjects.

Otherprogram 110: A language-independent program or fragment (expression) used to specify low-level actions, Boolean conditions, etc. It is primarily used with GrafcetPrograms, but it is also used in other places where it is appropriate for the user to specify custom behavior (e.g., MMI). The two languages supported in the specific embodiment are C and LISP. (These subclasses are completely interchangeable: the user can choose whichever is best suited to a particular situation.)

GrafcetObject 103: The pieces from which Grafcet "flowcharts" are assembled.

GrafcetStep 111: A "node" is a Grafcet "flowchart" that is activated when control passes to it and is deactivated when control passes out. Control passes as a result of a change in value of a GrafcetTransition 112. A GrafcetStep that is displayed on the screen while a simulation is running will be highlighted when it is activated.

GrafcetRegularStep 145: A GrafcetStep that contains up to three OtherPrograms that specify the actions taken i) when the step is activated, ii) continuously while the step is active, and iii) when the step is deactivated, respectively.

GrafcetMacroStep 146: A GrafcetStep that contains another Grafcet "flowchart" (a GrafcetMacroProgram).

GrafcetMMFSStep 147: A library GrafcetStep for specifying MMFS message templates and send and receive behavior.

GrafcetReceiptStep: A GrafcetStep that contains MMFSReceiveTemplates for MMFSMessages to be received on some specified connection(s). When a message is received and a matching template is found, parameters are stored and actions taken according to specifications in the template.

GrafcetSendStep 164: A GrafcetStep that contains MMFSSendTemplates and specifications for building and sending MMFSMessages.

GrafcetTransition: An object which connects two or more GrafcetSteps and specifies a boolean condition (an OtherProgram expression). The value of the boolean condition determines when control can pass from the preceding GrafcetStep(s) through the transition to the succeeding GrafcetStep(s) in the Grafcet "flowchart".

GrafcetLink 113: A connector between GrafcetSteps and GrafcetTransitions. Various types of links indicate one-to-one connections, or synchronous or asynchronous parallel splits or joins.

Folder 104: A collection of objects of a similar type. Some are permanent parts of the user's program (e.g., MMFSTemplateeFolder), while others are temporarily created by the system to display various information (e.g., MessageTraceFolder, AnalysisFolder). Folders are displayed and their contents manipulated by FolderBrowsers.

ModuleFolder 114: The top level user interface for manipulating modules ("main programs" created on the system) as a whole. Provides the capability to create, delete, copy, rename, compile, load and save modules, and to invoke various other types of Browsers on them.

MMFSTemplateFolder 115: Contains user-specified templates for sending or receiving MMFSMessages.

MessageTraceFolder 116: Contains network messages sent and/or received on specified connections or groups of connections.

StateVariableFolder 117: Contains lists of user variables and their current values.

NetworkConnectionFolder 118: Contains user specified parameters describing network connections.

AnalysisFolder 166: Contains lists of objects derived from analysis of the user's program in response to queries regarding the location of reference to variables, calls to functions, etc.

TransmissionMessage 119: A message to be sent on, or received from, a communications network or device. MAP (Manufacturing Automation Protocol) and IMS (Maxitron) networks may be supported in a specific embodiment. A TransmissionMessage contains information pertinent to transmission on a particular type of network (e.g., source and destination addresses), and an ApplicationMessage.

ApplicationMessage 110: An application-level message with data (contents) formatted according to some application protocol (e.g., MMFS, MMS). Any application level protocol can be used with any type of network by using the appropriate combination of TransmissionMessage and ApplicationMessage.

Browser 106: A screen window that provides the user with an interface to an object and some Context operating on that object. The same type of Browser may apply to multiple types of Contexts of objects (e.g. SimulationBrowser).

FormEditor 121: General purpose editor for viewing and editing fields of structured objects such as message templates, connection parameters, profile information.

GrafcetProgramEditor 124: Graphical editor for Grafcet "flowcharts". Allows GrafcetSteps, GrafcetTransitions and GrafcetLinks to be added, deleted, copied, renamed, zoomed, etc.

GrafcetStructureBrowser 125: Displays the hierarchical structure of one or more Grafcet Programs.

SimulationBrowser 126: Monitoring and control interface to the (local) simulation or (remote) execution of a Grafcetprogram. Allows the user to start, stop or single step the program, set breakpoints, display variable values, etc.

AnimationBrowser 127: Displays a running animation of factory devices.

AnimationEditor 124: Allows the user to create and edit animations of factory devices.

MMIBrowser 129: Man-Machine Interface "Control console" interface to programs.

MMIScreenEditor 130: Allows the user to create and edit MMI screens and establish their interaction with a Program.

ManualMessageBrowser 131: Allows the user to manually establish and break network connections, and send, receive and trace messages to and from remote devices and processes.

Context 107: A set of related operations that can be performed on an object, such as editing, simulation and analysis. The capabilities of a Context are presented to the user via a Browser.

LocalGrafcetSimulationContext 156: The "execution engine" for running programs locally. Consists of a Grafcet interpreter and facilities for handling breakpoints, starting, stopping, stepping and displaying real time status of programs.

RemoteGrafcetExecutionContext 157: The "execution engine" for running programs remotely. Exchanges command and monitoring information between a SimulationBrowser and an execution engine running on a remote machine. (In Figure 5 this is shown as cc-3.)

Network 108: Provides a consistent interface to a physical communication network, or simulates such a network for internal connections.

The invention has now been particularly described with reference to preferred embodiments. It will nevertheless be understood by those skilled in the art that the foregoing and other advantages in the form and detail may be made therein without departing from the spirit and scope of the invention. For example, the invention is not necessarily limited to use in a manufacturing environment, as it can be used in connection with any system of asynchronous processes adapted for exchange of information under automatic control. It is therefore not intended that the invention be limited, except as indicated by the appended claims.

## Claims

1. An apparatus for designing and debugging a control system comprising in combination:
means for preparing a specification, including means for developing requirements and documenting said requirements;
means for designing and organizing said control system including developing a system approach and its documentation;
means for developing said control system including implementing said system approach as a design implementation and generating its documentation to produce a developed system;
means for simulating and emulating said control system, including activating the design implementation in an artificial environment to demonstrate control system dynamics;
means for debugging said system, including means to isolate and correct cause of undesired behavior using simulation techniques to anticipate eventual behavior;
means for translating and transferring the developed system into an operational system;
means for integrating and checking out said control system in an operating environment, including means for verifying that each element of the operational system interacts and cooperates properly with the other ones of said elements;
means for monitoring and interacting with the operational system;
means for diagnosing malfunctions of devices and undesired behavior in the operational system; and means for modifying the operational system by modification of said specification.

2. A computer program for designing, constructing and interacting with a control system, said control system comprising functional elements running on computer processors, said functional elements capable of operating concurrently and asynchronously, said computer program comprising in combination:

means for designing said control system as a combination of objects, including means for creating a visual representation of said control system;

means coupled to said designing means for generating actual instructions that implement said control system from said objects;

means coupled to said generating means for sending said actual instructions to selected ones of said computer processors;

a run time module that operates on selected ones of said computer processors and controls the execution of said actual instructions; and

means coupled to said computer processors and to said designing means for allowing said run time module to interact with said objects whereby a user interacts with a single representation of said control system for specifying, designing and implementing said control system.

3. A method for designing, constructing and interacting with a control system, said control system comprising functional elements running on computer processors, said functional elements capable of operating concurrently and asynchronously, comprising the steps of:

designing said control system by creating a plurality of interacting objects;

generating actual instructions that implement said control system from said objects, thereafter;

simulating the effect of the actual instructions;

sending said actual instructions to selected ones of said computer processors;

operating a run time module on said selected ones of computer processors to control the execution of said actual instructions; and

allowing said run time module to interact with said objects, whereby a user interacts with a single common representation of said control system for specifying, designing and implementing said control system.

4. A computer program comprising in combination:

a plurality of design objects for designing a control system that includes functional elements that may operate concurrently and asynchronously;

programming objects which provide a means for generating a graphical description of a set of concurrent asynchronous functional elements that comprise an integrated control system;

programming objects which provide means for generating programming code that implements said integrated control system; and

a run time module means for managing the execution of a portion of said integrated control system, whereby a complex system can be easily designed and implemented.

5. The system recited in claim 4 further including:

programming objects that provide means for generating means for communicating between concurrently operating ones of said functional elements.

6. The system recited in claim 5 further including:

programming objects that include means for simulating the operation of said integrated control system.

7. The invention recited in claim 4 further including a programming object for creating visual images of Grafcet objects.

8. The invention recited in claim 4 further including communicating objects for communicating information between said functional elements.

9. The invention recited in claim 4 further including means for communicating information using the Manufacturing Automation Protocol.

10. The invention recited in claim 1 further including means for communicating information using the Manufacturing Automation Protocol.

FIG.\_I.

FIG.\_2.

COMPUTER

MAP GATEWAY

2A — CELL
2B — CELL
2C — CELL
2D — CELL
2E — CELL

CELL — 2F
CELL — 2G
CELL — 2H
CELL — 2I
CELL — 2J

FIG._3.

RTM IS RUN TIME MODULE

TOI IS TABLE OF INFORMATION

CS C SOURCE CODE

FIG._4.

EP 0 315 002 A2

FIGURE 5

```
                                         ┌GrafcetMainProgram (141)
                        ┌──GrafcetProgram (109)
                        │                └GrafcetMacroProgram (142)
      ┌──Program (102)──┤
      │                 │              ┌CProgram (143)
      │                 └─OtherProgram (110)
      │                                └LispProgram (144)
      │
      │                              ┌GrafcetRegularStep (145)─GrafcetInitialStep (162)
      │                  ┌─GrafcetStep (111)──GrafcetMacroStep (146)
      │                  │           │                    └GrafcetProcessStep (163)
      │                  │           └GrafcetMMFSStep (147)──GrafcetSendStep (164)
      │                  │                        └GrafcetReceiveStep (165)
      ├─GrafcetObject (103)───GrafcetTransition (112)
      │                  │                   ┌────GrafcetAsynchronousLink (148)
      │                  └─GrafcetLink (113)──GrafcetSynchronousLink (149)
      │                                      └────GrafcetRemoteLink (150)
      │
      │     ┌──ModuleFolder (114)
      │     ┌──MMFSTemplateFolder (115)
      │     ┌MessageTraceFolder (116)
      ├─Folder─StateVariableFolder (117)
      │     └NetworkConnectionFolder (118)
      │     └──AnalysisFolder (166)
      │                                 ┌──MAPMessage (151)
      │                   ┌─TransmissionMessage (119)
      │                   │             └──INSMessage (152)
      │                   │                          ┌MMFSMessage (158)
      ├──CommunicationObject (105)   ┌MMFSMessageDefinition (153)──MMFSSendTemplate (159)
Object (101)              └─ApplicationMessage (120)  └MMFSReceiveTemplate (160)
      │                        └MMSMessageDefinition (154)──MMSMessage (161)
      │                        └UnformattedMessage (155)
      │       ┌───FormEditor (121)
      │       ┌──CProgramEditor (122)
      │       ┌──FolderBrowser (123)
      │       ┌GrafcetProgramEditor (124)
      ├─Browser (106)──GrafcetStructureBrowser (125)
      │       │└SimulationBrowser (126)
      │       └──AnimationBrowser (127)
      │       └──AnimationEditor (128)
      │       └─MMIBrowser (129)
      │       └──MMIScreenEditor (130)
      │       └──ManualMessageBrowser (131)
      │       ┌──FormContext (132)
      │       ┌──FolderContext (133)
      │       │                         ┌───LocalGrafcetSimulationContext (156)
      │       ┌GrafcetSimulationContext (134)
      │       │                         └──RemoteGrafcetExecutionContext (157)
      │       ┌GrafcetProgramContext (135)
      ├─Context (107)──CProgramContext (136)
      │       └AnimationContext (137)
      │       └─MMIContext (138)
      │              ┌──MAPNetwork (139)
      └──Network (108)
                     └──INSNetwork (140)
```

FIGURE 6